# EUROPEAN PATENT SPECIFICATION

(11) **EP 0 215 436 B1**
(45) Date of publication and mention of the grant of the patent: **17.03.1993**
(21) Application number: 86112487.3
(22) Date of filing: 09.09.1986
(51) Int. Cl.: H01L 21/203, C30B 23/02, C30B 29/40

(54) **Method of growth of thin film layer for use in a composite semiconductor**
Verfahren zum Wachstum einer dünnen Schicht für einen zusammengesetzten Halbleiter
Méthode de croissance d'une couche mince pour semi-conducteur composite

(30) Priority: 09.09.1985 JP 198878/85; 10.09.1985 JP 200872/85; 20.09.1985 JP 209753/85
(43) Date of publication of application: 25.03.1987
(60) Divisional application: 92107691.5
(73) Proprietor: SUMITOMO ELECTRIC INDUSTRIES LIMITED, Osaka-shi, Osaka 541 (JP)
(72) Inventor: Matsui, Yuichi OSAKA WORKS OF SUMITOMO LTD., Osaka-shi Osaku-fu (JP)
(74) Representative: Eitle, Werner, Dipl.-Ing.

(56) References cited:
- EP-A- 0 183 146
- US-A- 3 915 765
- US-A- 3 992 233
- APPLIED PHYSICS LETTERS, vol. 36, no. 10, May 1980, pages 833-835, American Institute of Physics, New York, US; M.T. NORRIS: "Composition control of GaxIn1-xAs films grown by MBE onto InP substrates"
- JOURNAL OF APPLIED PHYSICS, vol. 52, no. 5, May 1981, pages 3445-3452, American Institute of Physics, New York, US; Y. KAWAMURA et al.: "Improved properties of InxGa1-xAs layers grown by molecular-beam epitaxy on InP substrates"

## Description

### FIELD OF THE INVENTION

The present invention relates to a method of growth of a thin film for use in a composite semiconductor, and more particularly to a method of growing crystal for providing composite semiconductor thin films for use in microwave elements, photo emissive elements and/or photo receiving elements.

### DESCRIPTION OF THE PRIOR ART

### Problem (1)

In the field of manufacturing high electron mobility transistor (referred to as HEMT hereinafter), it is necessary to form a thin layer of a few tens to a few hundreds of nm (hundreds to a few thousand angstroms) thickness as a channel layer.

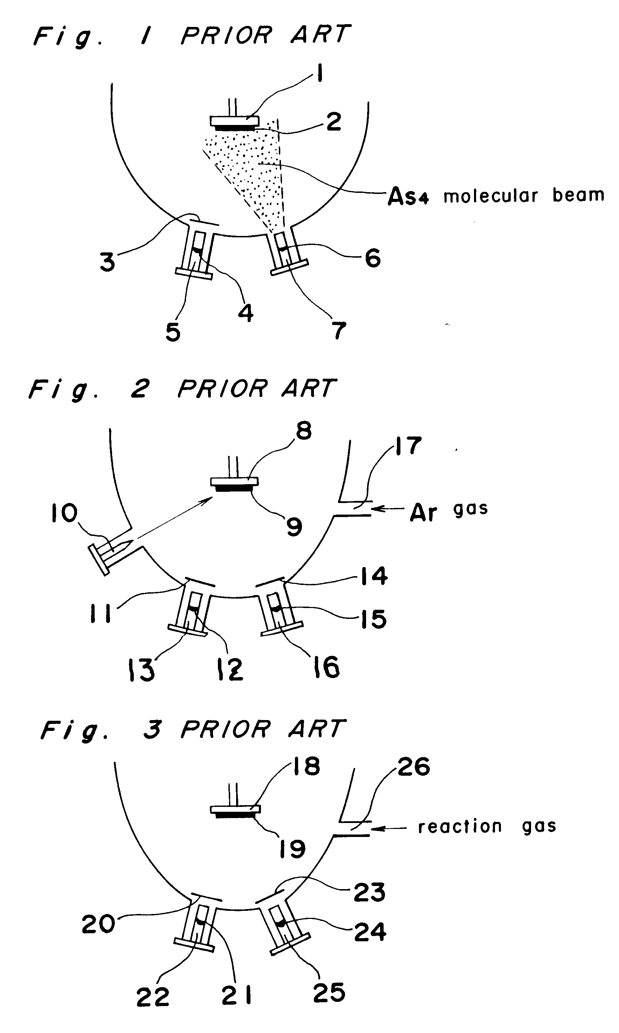

If there remain impurities on a surface of a substrate before the thin film is formed, the electric characteristic of the thin film layer formed on the substrate is lowered and the condition of the surface of the substrate appears as the characteristic of the thin film layer. In order to avoid such drawbacks, conventionally a way of thin film growth mentioned below has been employed. Figs. 1, 2 and 3 are schematic diagrams showing top plan view of an apparatus for the process of a so called molecular beam epitax = y (MBE) method in the conventional III-V composite semiconductor.

Referring to Fig. 1, 1 denotes a holder for holding a substrate 2, 3 denotes a cell shutter, 4 denotes III group sample such as Ga or In, 5 and 7 denote cells and 6 denotes V group sample such as As or P. In the method of growing III-V group composite semiconductor thin film by the conventional MBE growth, the V group elements are converted into atomic states or molecular states in the high vacuum growing chamber and radiated from the cell 7, whereby the substrate is heated up to a high temperature by illuminating light to the substrate 2 suppressing removal of the V group elements from the substrate 2 so that the impurities situated on the surface of the substrate are removed. However in the conventional method mentioned above, in order to fully remove the impurities on the substrate, it is necessary to heat the substrate up higher than a critical temperature. Heating the substrate higher than the critical temperature may cause the substrate holder 1 to be heated up to a high temperature by the heat conduction, resulting in increment of removed gas from the substrate holder 1. As a result, the background vacuum is also badly lowered thereby growing the impurities greatly and the electronic characteristic is lowered. Besides, in case after growing of the thin film on the substrate 2 and shaping of electrodes and fine shaping in the atmosphere, a top thin film layer is grown again, it is necessary to remove the impurities situated on the thin film of the lower layer. In this event, if the semiconductor chip is heated up above the critical temperature, there may occur an alloying reaction in both thin film of the lower layer and surface electrode metal, then the thin film of the lower layer is damaged. In addition, in case the lower layer is formed of multi thin layers, there occurs diffusion of the doping atoms between the two adjacent thin layers and mother atoms, thereby lowering the electronic characteristics on the interface of the thin film and the thin film per se.

Another MBE method of growing III-V group composite semiconductor thin layer is shown in Fig. 2, wherein 8 is a substrate holder, 9 is a substrate, 10 is an ion gun, 11 and 14 are cell shutters, 12 is a III group material, 13 and 16 are cells, 15 is V-group material and 17 is an entrance for Argon gas. In the method shown in Fig. 2, Ar ion beam is projected by the ion gun 10 onto the surface of the substrate 9 by introducing the Ar gas in the vacuum device, whereby the surface of the substrate 9 is cleaned off without temperature rise. However, radiation of the Ar beam causes the surface of the substrate 9 to be remarkably optically damaged and the crystal characteristic is disturbed, whereby a lot of defaults occur. As a result the crystallization and the electronic characteristic of the surface of the top layer grown on the substrate are lowered.

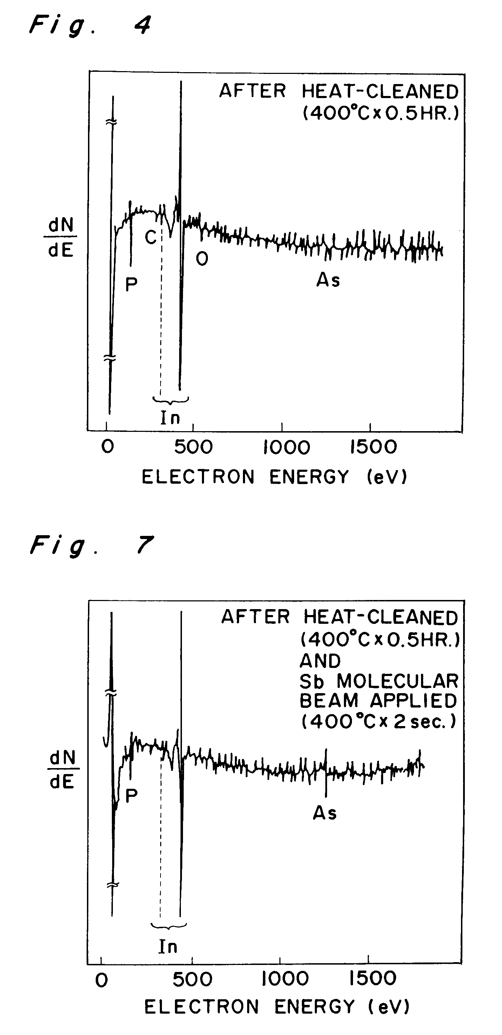

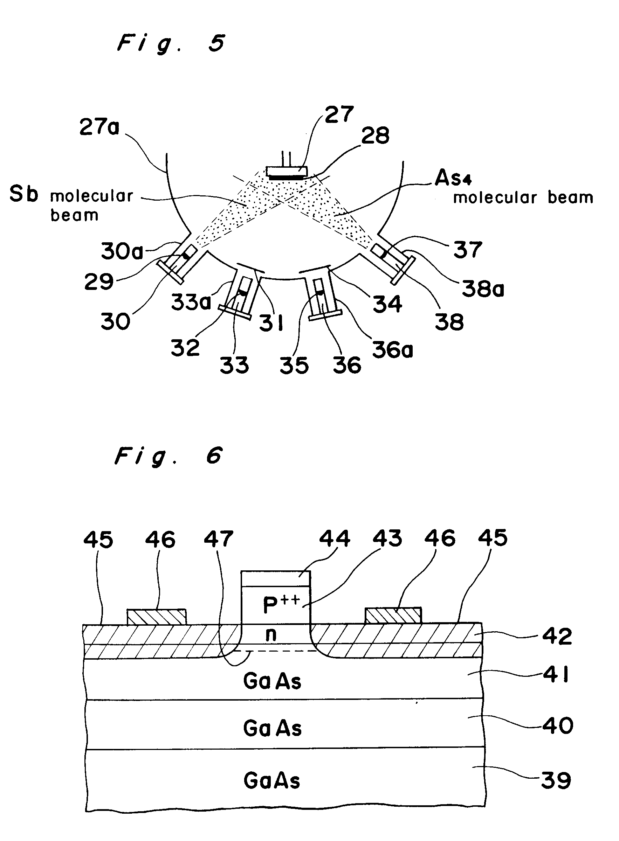

A further approach is to use so called a vapor phase epitaxial growth as the MBE method wherein there is used as shown in Fig. 3 a chemical vapor phase etching against the surface of the substrate by means of reactive gas such as HCL gas immediately before the crystal growth. In Fig. 3, 18 is a substrate holder, 20 and 23 are cell shutters, 21 is a III group material, 22 and 25 are cells, 24 is V group material and 26 is an entrance to introduce the reaction gas. In the method shown in Fig. 5, it is possible to clean the surface of the substrate without causing the substrate to be heated or damaged. However, in the method shown in Fig. 3, to introduce the reaction gas into the vacuum device causes the material forming the vacuum device and exhausting path of the vacuum device to be undesirably etched, in addition the reaction gas may reacts with fine wires such as heaters. These phenomena invite serious problems for the stable operation of the vacuum device. To etch the members of the device other than the substrate causes to generate impurity gas, thus the electronic characteristic of the III-V group composite semiconductor formed after the etching is lowered.

US-A-3 992 233 describes a method whereby Group III-V compound substrates are heat cleaned under vacuum conditions by heating above their congruent temperature (about 700°C for Ga As substrate) and subjecting the substrate to at least one molecular beam of the material preferentially evaporating from the substrate thereby maintaining surface stoichiometry. Surfaces so cleaned may then have an epitaxial layer grown thereon under similar conditions from molecular beams. Alternatively, the cleaned surface may be coated with cesium and oxygen to form a photocathode.

### Problem (2)

There has been expected the possibility of improvement of the electric characteristics of the semiconductor device by accumulating alternative periodic construction of the growth layers of different composition each having only 1 atomic layer. Such construction is referred to as mono atomic supper lattice or MSL. This has been reported in T.Yao, J J A P 22, (1983) L 680.

The conventional method of making the MSL is to alternatively open and close the shutters 3 and 3'so as to grow the GaAs layer and AlAs layer alternatively periodically and to obtain a hetero interfaces.

However, the hetero interfaces grown by the conventional method has a disadvantage that the surface of the hetero interface is not flat but is fluctuated with wore than 1 atomic thick. Such fluctuation or projection and recess of the surface of the hetero interface causes the light wave length radiated from a quantum well type light emission element to be shifted and lowering the control of the characteristic of the light emission element. Besides, in case of microwave element in which the current flows in parallel with the hetero interface such as a high electron mobility transistor (HEMT), there occurs electron scattering due to the fluctuation on the surface of the hetero interface, resulting in lowering the electron mobility and operation speed of the microwave element. Also since the surface of the hetero interface is fluctuated more than 1 atomic thick it has not been made to form the MSL on over all surface of the wafer of 2 inch diameter.

There further has been proposed to control the surface of the growth layer without the fluctuation of 1 atomic thick through observation of the growing layer by the reflection electron beam diffraction during MBE growth. (Sakamoto et al J J A P 23 (1984) L657.) However, in fact it has been impossible to suppress the fluctuation of the surface of the hetero interface even if the the above method was used. (Preliminary literature at 32 conference of applied physics 31P-ZA 12,(1985) P744.)

### SUMMARY OF THE INVENTION

An essential object of the present invention is to provide a method of growth of a thin film layer in a composite Semiconductor which enables to form the thin film layer having a desired characteristics without being effected by the state of the surface of the substrate and the lower film layer.

A further object of the present invention is to provide a method of manufacturing a thin film layer of the composite semiconductor in which the impurities in a ssubstrate or a lower layer of the composite semiconductor can be completely removed without causing the surface of the substrate or lower layer to be damaged by radiation of molecular beam.

A still further object of the present invention is to provide a method of manufacturing a thin film layer of the composite semiconductor in which the high speed electron mobility can be obtained. According to the present invention, there is provided a method of growing a thin film on a III-V semiconductor substrate by molecular beam epitaxy comprising the steps of: projecting an electrically neutral molecular beam onto said substrate surface in order to remove impurity molecules from said surface and; subsequently growing a thin III-V semiconductor layer on said substrate surface by molecular beam epitaxy, **characterized in that** said substrate is maintained at a temperature of 300-500°C; said molecular beam is of Sb or a Group III element; the number of atoms projected onto said substrate surface is less than the number of atoms required to form a single atomic layer.

In order to overcome the problem (1) being inherent in the prior arts as mentioned above, the present inventor conducted various studies through Auger electron spectrophotometric analysis of the composite semiconductor substrate and the lower layer of the composite semiconductor substrate. Then the present inventor has discovered the following phenomena. For example, after thermal cleaning of an InP substrate at 400° C for 1 hour under radiation of arsenic (As) molecules of V group elements, there remain impurity atoms such as C (carbon) and O (oxygen) on the surface of the InP substrate. However, in the cleaning process mentioned above, it has been found that the Auger electron peak caused by the impurity atoms such as oxygen (O) or carbon (C) could be removed as shown in Fig. 4 by the radiation of Sb molecules for 2 seconds at the time immediately before finish of the above cleaning process. A similar phenomenon could be observed by radiating Sb molecule beam at the time immediately before finish of the cleaning process which was performed at 400°C for 10 minutes. Moreover, in case Sb molecular beam is radiated, it is necessary that the number of Sb atoms used for radiation is smaller than the number of atoms forming one atomic layer of the composite semiconductor substrate or the lower layer film of the composite semiconductor. This is because if excessive number of III group of atoms which is more than the atoms necessary to form one atomic layer is radiated, even after cleaning of the impurity atoms such as. oxygen (O) and carbon (C) atoms, there remain a large number of excessive Sb atoms, which change the structure and atomic distance of the the surface of the lower layer of the composite semiconductor. Such change of the structure and atomic distance give bad effect to the growth of the layer of the composite semiconductor. In case of an example shown In Fig. 7 showing the spectrum of Auger electron spectorophotometery wherein the Sb atomic beam is radiated under such condition that the number of atoms is about 3/10 of the number of atoms necessary for forming one atomic layer. From the experiments, it can be seen that the peaks of oxygen (O) and carbon (C) are removed. Moreover, Sb peak is also removed. This shows that InP surface can be fully cleaned up and none of the excessive Sb atoms remain on the InP surface. The cleaning effect mentioned above could be seen in case where the temperature of the substrate was 300° C to 500° .

Thus it is found that radiation of Sb molecular beam with the number of atoms not more than the number of atoms necessary for one atomic layer enables to remove the impurity atoms on the composite semiconductor substrate or the surface of the lower layer of the composite semiconductor below the critical temperature. Also different from method of radiation of the ion beam, radiation of the neutral atomic beam does not injure the surface of the substrate. Moreover, the method according to the present invention does not etch the vacuum device per se as occur when the reaction gas is used.

### BRIEF EXPLANATION OF THE DRAWINGS

Fig. 1 is a partial top plan view of a vacuum device used in a conventional method of growing a thin film layer of a composite semiconductor,
Fig. 2 is a a partial top plan view of a vacuum device used in another conventional method of growing a thin film layer of a composite semiconductor,
Fig. 3 is a partial top plan view of a vacuum device used in a conventional method of growing a thin film layer of a composite semiconductor,
Fig. 4 is a graph showing the peak value of the Auger electron spectra according to the composite semiconductor according to the present invention, in which the vertical axis represents the value dN/dE and the horizontal axis represents the value of electron energy,
Fig. 5 is a partial plan view of a vacuum device for use in a method of the growth of thin film layer of the composite semiconductor according to the present invention,
Fig. 6 is a cross sectional view of a composite semiconductor formed by the method according to the present invention,
Fig. 7 is a graph showing the peak value of the Auger electron spectra of a prior art composite semiconductor.

### DETAILED DESCRIPTION OF THE PREFERRED EMBODIMENTS

### Example 1

Referring to Fig. 5, a substrate holder 27 is situated at the center of a cylindrical vacuum device 27a. Placed on the front surface of the substrate holder 27 is an InP substrate. Four cylindrical cells 30, 33, 36 and 38 are disposed so as to radially project from the sylindrical wall of the vacuum device 27a and they are enclosed arm pipes 30a, 33a, 36a and 38a. Sb material 29, In material 32 of III group material, Ga material 35 and As material 37 are respectively put in the cells 30, 33, 36 and 38 which are directed toward the substrate holder 27 to radiate respective atomic beams from the materials toward the InP substrate.

In the example 1 shown in Fig. 5, InP substrate 28 was heated by the As₄ molecular beam up to about 400 °C for about 10 minutes keeping the vacuum of the area near the substrate with 1.33 x 10⁻⁴ to 1.33 x 10⁻^{3Pa} (1 x 10⁻⁶ Torr to 1 x 10⁻⁵ Torr) and the vacuum of the background with about 6.67 x 10⁻^{3Pa} (5 x 10⁻⁵ Torr), subsequently Sb molecular beam of about 1.33 x 10⁻^{6Pa} (1 x 10⁻⁸ Torr) was radiated to the substrate 28 for about 2 seconds. Thereafter, the cell shutter 31 of the In cell 33 and cell shutter 34 of the Ga cell 36 were opened so as to continuously grow the thin film of In_{0.53} Ga_{0.47} As of 0.2 µm on the InP substrate 28. In case where 0.2 µm of In_{0.53} Ga_{0.47} As was formed on the semi insulation InP substrate by means of the example 1, the electron mobility under the room temperature was 11,000 cm²/V sec and the carrier density was 1 x 10¹¹ cm⁻³. To the contrary, in case where the thin film of In_{0.53} Ga_{0.47} As of 0.2 µm was formed on the InP substrate by only thermal cleaning of 400° C for 10 minutes radiating As₄ molecular beam or 1 x 10⁻⁵ Torr, the electron mobility under the room temperature was 8,000 cm²/V sec and the carrier density was 2 x 10¹⁶/cm. As apparent from the foregoing, according to the example 1, the impurity carrier density in the semiconductor can be extraordinally reduced and the electron mobility can be increased and the electric characteristics of the In_{0.53} Ga_{0.47} As layer can be improved.

### Example 2

The same process as shown in the example 1 was performed except that Ga atoms were used in place of Sb atoms and III group molecular beam such as In molecular beam was used in place of Sb molecular beam. The same effect as in the example 1 could be obtained.

In_{0.53}Ga_{0.47}As thin layer of not more than 0.2 µ m thick was made using the method of the example 2 in which In molecular beam was used in place of using Ga molecular beam. The electron mobility under the room temperature was 10500cm²/V.sec., and the carrier density was 1.5 x 10¹³ cm⁻³.

In this case, it was possible to improve the electron characteristics in the thin film layer. The same effect could be recognized under the substrate temperature of 300 to 500 °C and it was possible to improve the electron characteristics of In_{0.53}Ga_{0.47}As thin film layer.

## Claims

1. A method of growing a thin film on a III-V semiconductor substrate by molecular beam epitaxy comprising the steps of:
projecting an electrically neutral molecular beam onto said substrate surface in order to remove impurity molecules from said surface and;
subsequently growing a thin III-V semiconductor layer on said substrate surface by molecular beam epitaxy,
**characterized in that**
said substrate is maintained at a temperature of 300-500°C;
said molecular beam is of Sb or a Group III element;
the number of atoms projected onto said substrate surface is less than the number of atoms required to form a single atomic layer.

2. The method according to claim 1, wherein said Group III molecular beam is an In or Ga molecular beam.

## Patentansprüche

1. Verfahren zum Wachstum eines Dünnfilms auf einem III-V-Halbleitersubstrat durch Molekularstrahlepitaxie mit folgenden Schritten:
Aufstrahlen eines elektrisch neutralen Molekularstrahls auf die Substratoberfläche, um Verunreinigungsmoleküle von der Oberfläche zu entfernen, und
nachfolgendes Wachstum einer dünnen III-V-Halbleiterschicht auf der Substratoberfläche durch Molekularstrahlepitaxie,
dadurch gekennzeichnet, daß
das Substrat auf einer Temperatur von 300 bis 500°C gehalten wird;
der Molekularstrahl aus Sb oder einem Element der Gruppe III besteht;
und die Anzahl der auf die Substratoberfläche aufgestrahlten Atome geringer ist als die Anzahl an Atomen, die zur Ausbildung einer einatomaren Schicht erforderlich ist.

2. Verfahren nach Anspruch 1, bei welchem der Molekularstrahl der Gruppe III ein In- oder Ga-Molekularstrahl ist.

## Revendications

1. Procédé de croissance d'un film mince sur un substrat semi-conducteur III-V par épitaxie par faisceau moléculaire, comprenant les étapes consistant à :
projeter un faisceau moléculaire électriquement neutre sur la surface dudit substrat pour éliminer les molécules d'impuretés de ladite surface, puis
faire croître une couche mince de semi-conducteur III-V sur la surface dudit substrat par épitaxie par faisceau moléculaire,
caractérisé en ce que :
ledit substrat est maintenu à une température de 300 à 500°C,
ledit faisceau moléculaire est constitué par Sb ou un élément du groupe III,
le nombre d'atomes projetés sur la surface dudit substrat est inférieur au nombre d'atomes nécessaires pour former une couche atomique unique.

2. Procédé selon la revendication 1, dans lequel ledit faisceau moléculaire du groupe III est un faisceau moléculaire de In ou Ga.
